# EUROPEAN PATENT APPLICATION

(11) **EP 4 761 542 A1**
(43) Date of publication of application: **17.06.2026**
(21) Application number: 23955301.9
(22) Date of filing: 24.11.2023
(51) Int. Cl.: H10K 59/131

(54) **DISPLAY PANEL AND DISPLAY APPARATUS**

(30) Priority: 12.10.2023 CN 202311323103
(71) Applicant: Wuhan China Star Optoelectronics Semiconductor Display Technology Co., Ltd., Wuhan, Hubei 430079 (CN)
(72) Inventor: DU, Zuchen, Wuhan, Hubei 430079 (CN)
(74) Representative: Stöckeler, Ferdinand
(86) International application number: PCT/CN2023/134048
(87) International publication number: WO 2025/076932

(57) **Abstract**

The present application provides a display panel and a display apparatus. In the display panel, two ends of a first connection line are electrically connected to two dummy pads, respectively; a first end of a second connection line and a first end of a third connection line are each electrically connected to a first connection line; a second end of the second connection line is electrically connected to a low-level power signal input pin; a low-level power signal output terminal of a flexible circuit board is electrically connected to both the low-level power signal input pin and a second end of the third connection line.

## Description

### TECHNICAL FIELD

The present application relates to the field of display technologies, and in particular, to a display panel and a display apparatus.

### BACKGROUND

The resolution of existing organic light-emitting diode (OLED) display panels is becoming increasingly higher, leading to greater power consumption by the driver chips. The increase in power consumption causes the temperature of the driver chips to rise excessively, which may affect their output capability and even result in the driver chips burning out, thereby reducing the display effect of the display panel. Therefore, effectively reducing the heat generation of the driver chips to control their temperature is an urgent problem that needs to be addressed.

### SUMMARY

The display panel and the display apparatus provided by the present application are intended to effectively reduce the heat generated by the driver chip to control the temperature of the driver chip.

In one aspect, some embodiments of the present application provide a display panel, which includes a substrate, a chip assembly, a connection trace, and a flexible circuit board. The substrate is disposed on the substrate. The chip assembly includes a low-level power signal input pin, a high-level power signal input pin, an output pin, and dummy pads. The low-level power signal input pin and the high-level power signal input pin are spaced apart from the output pin at opposite sides of the chip assembly, and at least part of the dummy pads are spaced between the low-level power signal input pin and the output pin. The connection trace includes first connection lines, a second connection line, and a third connection line. Two ends of one of the first connection lines are electrically connected to two of the dummy pads, respectively; a first end of the second connection line and a first end of the third connection line are each electrically connected to one of the first connection lines; a second end of the second connection line is electrically connected to the low-level power signal input pin. The flexible circuit board is disposed on at least one side of the substrate. The flexible circuit board includes a low-level power signal output terminal and a high-level power signal output terminal, the low-level power signal output terminal is electrically connected to both the low-level power signal input pin and a second end of the third connection line, and the high-level power signal output terminal is electrically connected to the high-level power signal input pin.

In another aspect, some embodiments of the present application further provide a display apparatus, which includes a display panel and a driving circuit electrically connected to the display panel and configured to drive the display panel. The display panel includes a substrate, a chip assembly, a connection trace, and a flexible circuit board. The substrate is disposed on the substrate. The chip assembly includes a low-level power signal input pin, a high-level power signal input pin, an output pin, and dummy pads. The low-level power signal input pin and the high-level power signal input pin are spaced apart from the output pin at opposite sides of the chip assembly, and at least part of the dummy pads are spaced between the low-level power signal input pin and the output pin. The connection trace includes first connection lines, a second connection line, and a third connection line. Two ends of one of the first connection lines are electrically connected to two of the dummy pads, respectively; a first end of the second connection line and a first end of the third connection line are each electrically connected to one of the first connection lines; a second end of the second connection line is electrically connected to the low-level power signal input pin. The flexible circuit board is disposed on at least one side of the substrate. The flexible circuit board includes a low-level power signal output terminal and a high-level power signal output terminal, the low-level power signal output terminal is electrically connected to both the low-level power signal input pin and a second end of the third connection line, and the high-level power signal output terminal is electrically connected to the high-level power signal input pin.

### BRIEF DESCRIPTION OF THE DRAWINGS

FIG. 1 is a schematic diagram of a first structure of a display panel according to some embodiments of the present application.
FIG. 2 is a schematic diagram of a second structure of the display panel according to some embodiments of the present application.
FIG. 3 is a first cross-sectional view of the display panel taken along direction AA' according to some embodiments of the present application.
FIG. 4 is a second cross-sectional view of the display panel taken along direction AA' according to some embodiments of the present application.
FIG. 5 is a third cross-sectional view of the display panel taken along direction AA' according to some embodiments of the present application.
FIG. 6 is a fourth cross-sectional view of the display panel taken along direction AA' according to some embodiments of the present application.
FIG. 7 is a schematic diagram of a third structure of the display panel according to some embodiments of the present application.

### DETAILED DESCRIPTION

Technical solutions in the embodiments of the present application will be described below with reference to the accompanying drawings in the embodiments of the present application. The described technical solutions are intended to explain and illustrate core ideas of the present application, and are not intended to limit the protection scope of the present application.

Some embodiments of the present application provide a display panel, which includes a substrate, a chip assembly, a connection trace, and a flexible circuit board. The substrate is disposed on the substrate. The chip assembly includes a low-level power signal input pin, a high-level power signal input pin, an output pin, and dummy pads. The low-level power signal input pin and the high-level power signal input pin are spaced apart from the output pin at opposite sides of the chip assembly, and at least part of the dummy pads are spaced between the low-level power signal input pin and the output pin. The connection trace includes first connection lines, a second connection line, and a third connection line. Two ends of one of the first connection lines are electrically connected to two of the dummy pads, respectively; a first end of the second connection line and a first end of the third connection line are each electrically connected to one of the first connection lines; a second end of the second connection line is electrically connected to the low-level power signal input pin. The flexible circuit board is disposed on at least one side of the substrate. The flexible circuit board includes a low-level power signal output terminal and a high-level power signal output terminal, the low-level power signal output terminal is electrically connected to both the low-level power signal input pin and a second end of the third connection line, and the high-level power signal output terminal is electrically connected to the high-level power signal input pin.

The plurality of dummy pads include a plurality of first dummy pads and a plurality of second dummy pads. The plurality of first dummy pads are arranged at intervals in a first direction and located between the low-level power supply signal input pin and the output pin. The plurality of second dummy pads are arranged at intervals in a second direction and located at a side of the low-level power supply signal input pin and a side of the output pin in the first direction. The first direction intersects the second direction. At least part of the plurality of first dummy pads are respectively electrically connected through the first connection lines to form a first path. At least part of the plurality of second dummy pads are respectively electrically connected through the first connection lines to form a second path. The first path is electrically connected to the second path through one of the first connection lines. The first path is electrically connected to the low-level power signal input pin through the second connection line. The second path is electrically connected to the low-level power signal output terminal through the third connection line.

The first connection lines are disposed among all of the plurality of first dummy pads, and every two adjacent first dummy pads are electrically connected through one of the first connection lines. The first connection lines are disposed among part of the plurality of second dummy pads close to a side of the flexible circuit board, and two adjacent second dummy pads are electrically connected through one of the first connection lines.

The connection trace further comprises a fourth connection line, a first end of the fourth connection line is electrically connected to the low-level power signal output terminal, and a second end of the fourth connection line is electrically connected to the low-level power signal input pin. The fourth connection line includes a first sub-connection line and a second sub-connection line, and the first sub-connection line is disposed on a side of the second sub-connection line away from the substrate; both a first end of the first sub-connection line and a first end of the second sub-connection line are electrically connected to the low-level power signal output terminal, and both a second end of the first sub-connection line and a second end of the second sub-connection line are electrically connected to the low-level power signal input pin. An insulating layer is provided between the first sub-connection line and the second sub-connection line, and an orthographic projection of the insulating layer on the substrate covers both an orthographic projection of the first sub-connection line on the substrate and an orthographic projection of the second sub-connection line on the substrate.

The insulating layer is provided with a through-hole, and the first sub-connection line is electrically connected to the second sub-connection line through the through-hole.

The plurality of first sub-connection lines are sequentially arranged at intervals in the first direction, and the plurality of second sub-connection lines are sequentially arranged at intervals in the first direction.

The orthographic projection of the first sub-connection line on the substrate at least partially covers the orthographic projection of the second sub-connection line on the substrate.

The connection trace further includes a plurality of fifth connection lines arranged at intervals in a first direction. A first end of one of the plurality of fifth connection lines is electrically connected to the low-level power signal output terminal, and a second end of the one of the plurality of fifth connection lines is electrically connected to the low-level power signal input pin. The display panel further includes a first metal layer, the insulating layer, and a second metal layer; the insulating layer is disposed between the first metal layer and the second metal layer, and the second metal layer is disposed on a side of the first metal layer away from the substrate; the plurality of fifth connection lines are arranged in a staggered configuration in the first direction on both the first metal layer and the second metal layer.

A cross-sectional width of one of the plurality of fifth connection lines in the first direction is greater than a cross-sectional width of the fourth connection line in the first direction.

A cross-sectional width of the second connection line in the first direction is greater than a cross-sectional width of one of the first connection lines in the second direction; a cross-sectional width of the third connection line in the first direction is greater than the cross-sectional width of the one of the first connection lines in the second direction. The first direction intersects the second direction.

Some embodiments of the present application further provide a display apparatus, which includes a display panel and a driving circuit electrically connected to the display panel and configured to drive the display panel. The display panel includes a substrate, a chip assembly, a connection trace, and a flexible circuit board. The substrate is disposed on the substrate. The chip assembly includes a low-level power signal input pin, a high-level power signal input pin, an output pin, and dummy pads. The low-level power signal input pin and the high-level power signal input pin are spaced apart from the output pin at opposite sides of the chip assembly, and at least part of the dummy pads are spaced between the low-level power signal input pin and the output pin. The connection trace includes first connection lines, a second connection line, and a third connection line. Two ends of one of the first connection lines are electrically connected to two of the dummy pads, respectively; a first end of the second connection line and a first end of the third connection line are each electrically connected to one of the first connection lines; a second end of the second connection line is electrically connected to the low-level power signal input pin. The flexible circuit board is disposed on at least one side of the substrate. The flexible circuit board includes a low-level power signal output terminal and a high-level power signal output terminal, the low-level power signal output terminal is electrically connected to both the low-level power signal input pin and a second end of the third connection line, and the high-level power signal output terminal is electrically connected to the high-level power signal input pin.

The plurality of dummy pads include a plurality of first dummy pads and a plurality of second dummy pads. The plurality of first dummy pads are arranged at intervals in a first direction and located between the low-level power supply signal input pin and the output pin. The plurality of second dummy pads are arranged at intervals in a second direction and located at a side of the low-level power supply signal input pin and a side of the output pin in the first direction. The first direction intersects the second direction. At least part of the plurality of first dummy pads are respectively electrically connected through the first connection lines to form a first path. At least part of the plurality of second dummy pads are respectively electrically connected through the first connection lines to form a second path. The first path is electrically connected to the second path through one of the first connection lines. The first path is electrically connected to the low-level power signal input pin through the second connection line. The second path is electrically connected to the low-level power signal output terminal through the third connection line.

Optionally, in some embodiments of the present application, the first connection lines are disposed among all of the plurality of first dummy pads, and every two adjacent first dummy pads are electrically connected through one of the first connection lines.

The first connection lines are disposed among part of the second dummy pads close to a side of the flexible circuit board, and two adjacent second dummy pads are electrically connected through one of the first connection lines.

Optionally, in some embodiments of the present application, the connection trace further includes a fourth connection line, a first end of the fourth connection line is electrically connected to the low-level power signal output terminal, and a second end of the fourth connection line is electrically connected to the low-level power signal input pin. The fourth connection line includes a first sub-connection line and a second sub-connection line, and the first sub-connection line is disposed on a side of the second sub-connection line away from the substrate; both a first end of the first sub-connection line and a first end of the second sub-connection line are electrically connected to the low-level power signal output terminal, and both a second end of the first sub-connection line and a second end of the second sub-connection line are electrically connected to the low-level power signal input pin. An insulating layer is provided between the first sub-connection line and the second sub-connection line, and an orthographic projection of the insulating layer on the substrate covers both an orthographic projection of the first sub-connection line on the substrate and an orthographic projection of the second sub-connection line on the substrate.

The insulating layer is provided with a through-hole, and the first sub-connection line is electrically connected to the second sub-connection line through the through-hole.

The plurality of first sub-connection lines are sequentially arranged at intervals in the first direction, and the plurality of second sub-connection lines are sequentially arranged at intervals in the first direction.

The orthographic projection of the first sub-connection line on the substrate at least partially covers the orthographic projection of the second sub-connection line on the substrate.

The connection trace further includes a plurality of fifth connection lines arranged at intervals in a first direction. A first end of one of the plurality of fifth connection lines is electrically connected to the low-level power signal output terminal, and a second end of the one of the plurality of fifth connection lines is electrically connected to the low-level power signal input pin. The display panel further includes a first metal layer, the insulating layer, and a second metal layer; the insulating layer is disposed between the first metal layer and the second metal layer, and the second metal layer is disposed on a side of the first metal layer away from the substrate; the plurality of fifth connection lines are arranged in a staggered configuration in the first direction on both the first metal layer and the second metal layer.

A cross-sectional width of one of the plurality of fifth connection lines in the first direction is greater than a cross-sectional width of the fourth connection line in the first direction.

A cross-sectional width of the second connection line in the first direction is greater than a cross-sectional width of one of the first connection lines in the second direction; a cross-sectional width of the third connection line in the first direction is greater than the cross-sectional width of the one of the first connection lines in the second direction. The first direction intersects the second direction.

In the display panel and the display apparatus provided by the embodiments of the present application, at least part of the dummy pads in the chip assembly are electrically connected by arranging the first connection lines; the first connection line are electrically connected to both the low-level power signal input pin and the low-level power signal output terminal of the flexible circuit board by arranging the second connection line. Meanwhile, the first connection line is electrically connected to the low-level power signal output terminal of the flexible circuit board by arranging the third connection line. These configurations are intended to reduce the impedance of the wiring between the chip assembly and the flexible circuit board, thereby effectively reducing the heat generated by the driver chip to control the temperature of the driver chip.

Various embodiments provided in the present application are similar, and features in different embodiments can be combined with each other.

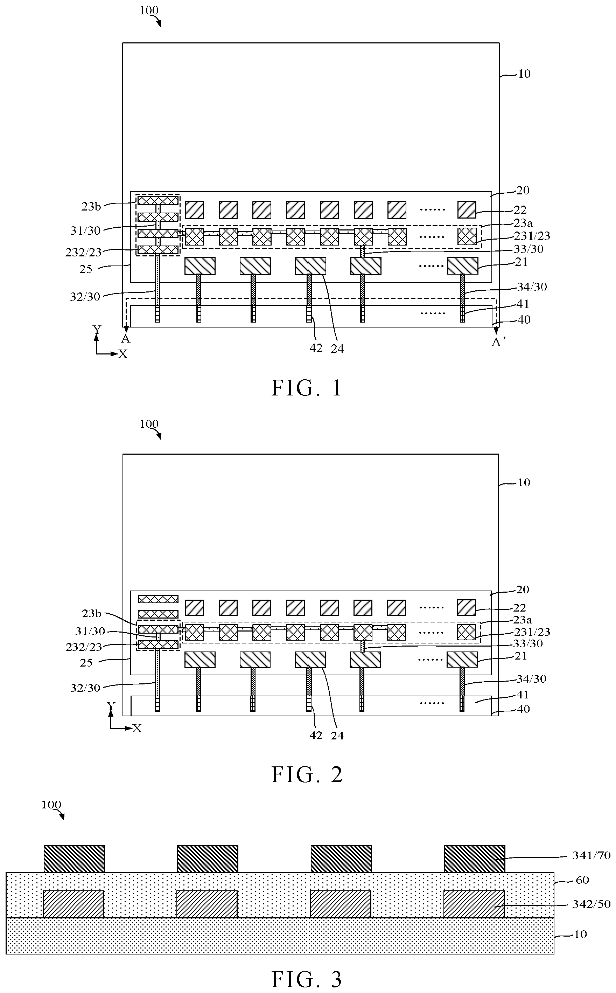

As shown in FIGs. 1 to 3, some embodiments of the present application provide a display panel 100, which includes a substrate 10, a chip assembly 20, a connection trace 30, and a flexible circuit board 40. The substrate 10 is disposed on the substrate 10. The chip assembly 20 includes a low-level power signal input pin 21, an output pin 22, dummy pads 23, and a high-level power signal input pin 24. The low-level power signal input pin 21 and the high-level power signal input pin 24 are spaced apart from the output pin 22 at opposite sides of the chip assembly 20. At least part of the dummy pads 23 are spaced between the low-level power signal input pin 21 and the output pin 22. Specifically, the level power signal input pin 21 and the high-level power signal input pin 24 are spaced apart from each other in the first direction X at a side of the chip assembly 20 that is close to the flexible circuit board 40. The connection trace 30 is disposed on the substrate 10. The connection trace 30 includes first connection lines 31, a second connection line 32, and a third connection line 33. Two ends of a first connection line 31 are electrically connected to two dummy pads 23, respectively. A first end of the second connection line 32 and a first end of the third connection line 33 are each electrically connected to a first connection line 31. A second end of the second connection line 32 is electrically connected to the low-level power signal input pin 21. The flexible circuit board 40 is disposed on at least one side of the substrate 10. The flexible circuit board 40 includes a low-level power signal output terminal 41 and a high-level power signal output terminal 42. The low-level power signal output terminal 41 is electrically connected to both the low-level power signal input pin 21 and a second end of the third connection line 33. The high-level power signal output terminal 42 is electrically connected to the high-level power signal input pin 24.

In the display panel provided by the embodiments of the present application, at least part of the dummy pads 23 in the chip assembly 20 are electrically connected by arranging the first connection lines 31; the first connection line 31 are electrically connected to both the low-level power signal input pin 21 and the low-level power signal output terminal 41 of the flexible circuit board 40 by arranging the second connection line 32. Meanwhile, the first connection line 31 is electrically connected to the low-level power signal output terminal 41 of the flexible circuit board 40 by arranging the third connection line 33. These configurations are intended to reduce the impedance of the wiring between the chip assembly 20 and the flexible circuit board 40, thereby effectively reducing the heat generated by the driver chip to control the temperature of the driver chip.

In some embodiments of the present application, the chip assembly 20 includes a plurality of low-level power supply signal input pins 21, a plurality of output pins 22, and a plurality of dummy pads 23. The plurality of low-level power supply signal input pins 21 are arranged at intervals in the first direction X. The plurality of output pins 22 are arranged at intervals in the first direction X. The low-level power supply signal input pin 21 and the output pin 22 are arranged at intervals in the second direction Y. The first direction X is a length direction of the chip assembly 20. The second direction Y is a width direction of the chip assembly 20.

In some embodiments of the present application, the plurality of dummy pads 23 include a plurality of first dummy pads 231 and a plurality of second dummy pads 232. The plurality of first dummy pads 231 are arranged at intervals in the first direction X and located between the low-level power signal input pins 21 and the output pins 22. The plurality of second dummy pads 232 are arranged at intervals in the second direction Y and located at a side of the low-level power signal input pins 21 in the first direction X and a side of the output pins 22 in the first direction X. The first direction X intersects the second direction Y. At least part of the first dummy pads 231 are respectively electrically connected through the first connection lines 31 to form a first path 23a. At least part of the second dummy pads 232 are respectively electrically connected through the first connection lines 31 to form a second path 23b. The first path 23a is electrically connected to the second path 23b through a first connection line 31. The first path 23a is electrically connected to the low-level power signal input pin 21 through the second connection line 32. The second path 23b is electrically connected to the low-level power signal output terminal 41 through the third connection line 33.

In some embodiments of the present application, the cross-sectional shape of the first dummy pad 231 in the horizontal direction is different from the cross-sectional shape of the second dummy pad 232 in the first direction X. Specifically, a cross-sectional width of the first dummy pad 231 in the first direction X is less than a cross-sectional width of the second dummy pad 232 in the first direction X; a cross-sectional width of the first dummy pad 231 in the second direction Y is greater than a cross-sectional width of the second dummy pad 232 in the second direction Y.

In some embodiments of the present application, the chip assembly 20 further includes a chip body 25. The chip body 25 is disposed on all of a side of the low-level power signal input pin 21, a side of the output pin 22, and a side of the dummy pad 23 that are away from the substrate 10. The chip body 25 is electrically connected to both the low-level power signal input pin 21 and the output pin 22.

As shown in FIG. 1, a first connection line 31 is disposed between every two adjacent dummy pads 23, and two adjacent dummy pads 23 are electrically connected through a first connection line 31.

As shown in FIG. 2, the first connection lines 31 are disposed among all of the plurality of first dummy pads 231, and every two adjacent first dummy pads 231 are electrically connected through a first connection line 31. The first connection lines 31 are only disposed among part of the second dummy pads 232 at the side close to the flexible circuit board 40, and two adjacent second dummy pads 232 are electrically connected through a first connection line 31. Part of the second dummy pads 232 at the side away from the flexible circuit board 40 are arranged at intervals and only used to support the chip body 25.

In some embodiments of the present application, the connection trace 30 further includes fourth connection lines 34. A first end of the fourth connection line 34 is electrically connected to the low-level power signal output terminal 41, and a second end of the fourth connection line 34 is electrically connected to the low-level power signal input pin 21. The fourth connection line 34 includes a first sub-connection line 341 and a second sub-connection line 342. The first sub-connection line 341 is disposed on a side of the second sub-connection line 342 away from the substrate 10. By configuring the fourth connection line 34 between the chip assembly 20 and the flexible circuit board 40 as a double-layer setup with the first sub-connection line 341 and the second sub-connection line 342, both the first end of the first sub-connection line 341 and the first end of the second sub-connection line 342 are electrically connected to the low-level power signal output terminal 41, and both the second end of the first sub-connection line 341 and the second end of the second sub-connection line 342 are electrically connected to the low-level power signal input pin 21. This configuration further reduces the impedance of the wiring between the chip assembly 20 and the flexible circuit board 40, thereby decreasing the heat generation of the chip assembly 20 to control its temperature. This prevents the chip assembly 20 from overheating, which could affect the output stability of the chip assembly 20 or cause the chip assembly 20 to burn out. Part of the fourth connection lines 34 are also used to connect the high-level power signal output terminal 42 to the high-level power signal input pin 24.

As shown in FIG. 3, the display panel 100 includes a first metal layer 50, an insulating layer 60, and a second metal layer 70. The insulating layer 60 is disposed between the first metal layer 50 and the second metal layer 70. The second metal layer 70 is disposed on a side of the first metal layer 50 that is away from the substrate 10. A plurality of fifth connection lines 35 are alternately arranged in the first direction X on both the first metal layer 50 and the second metal layer 70. The second metal layer 70 includes the first sub-connection line 341, and the first metal layer 50 includes the second sub-connection line 342. An orthographic projection of the insulating layer 60 on the substrate 10 covers both an orthographic projection of the first sub-connection line 341 on the substrate 10 and an orthographic projection of the second sub-connection line 342 on the substrate 10.

In some embodiments of the present application, the orthographic projection of the first sub-connection line 341 on the substrate 10 at least partially covers the orthographic projection of the second sub-connection line 342 on the substrate 10. That is, the cross-sectional width of the first sub-connection line 341 in the first direction X is greater than or equal to the cross-sectional width of the second sub-connection line 342 in the first direction X, and the first sub-connection line 341 at least partially overlaps with the second sub-connection line 342. FIG. 3 exemplarily shows that the cross-sectional width of the first sub-connection line 341 in the first direction X is equal to the cross-sectional width of the second sub-connection line in the first direction X, and the orthographic projection of the first sub-connection line 341 on the substrate 10 covers the orthographic projection of the second sub-connection line 342 on the substrate 10.

In some embodiments of the present application, the cross-sectional width of the second connection line 32 in the horizontal direction, the cross-sectional width of the first connection line 31 in the horizontal direction, and the cross-sectional width of the third connection line 33 in the horizontal direction are all equal.

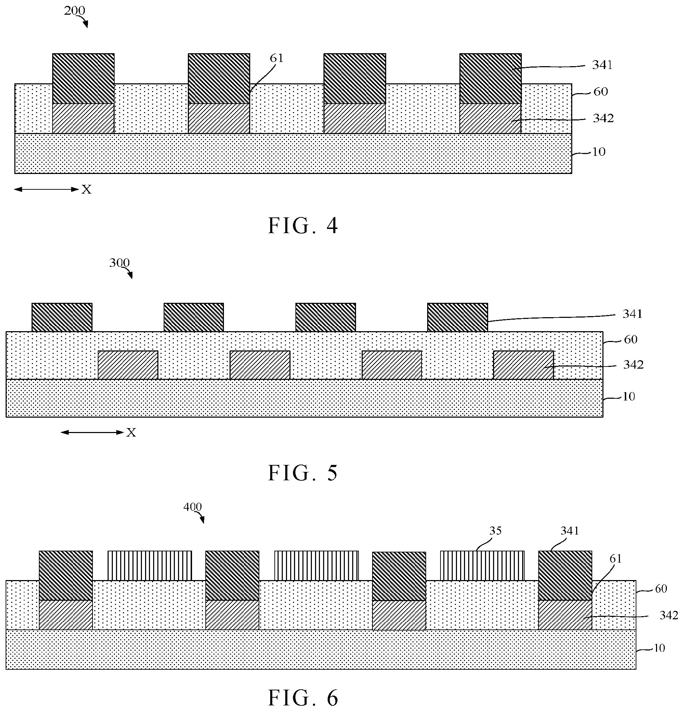

As shown in FIG. 4, some embodiments of the present application provide a display panel 200, which differs from the display panel 100 in that the insulating layer 60 of the display panel 200 is provided with a through-hole 61, and the first sub-connection line 341 is electrically connected to the second sub-connection line 342 through the through-hole 61.

In some embodiments of the present application, the orthographic projection of the first sub-connection line 341 on the substrate 10 covers the orthographic projection of the second sub-connection line 342 on the substrate 10; the cross-sectional area of the through-hole 61 in the first direction X is less than or equal to the cross-sectional area of the second sub-connection line 342 in the horizontal direction; the cross-sectional area of the second sub-connection line 342 in the horizontal direction is less than or equal to the cross-sectional area of the first sub-connection line 341 in the horizontal direction.

FIG. 4 exemplarily shows that the orthographic projection of the first sub-connection line 341 on the substrate 10 covers the orthographic projection of the second sub-connection line 342 on the substrate 10, the cross-sectional area of the through-hole 61 in the first direction X is equal to the cross-sectional area of the second sub-connection line 342 in the first direction X, and the cross-sectional area of the second sub-connection line 342 in the first direction X is equal to the cross-sectional area of the first sub-connection line 341 in the horizontal direction.

In some embodiments of the present application, the orthographic projection of the first sub-connection line 341 on the substrate 10 partially covers the orthographic projection of the second sub-connection line 342 on the substrate 10. The through-hole 61 is disposed corresponding to the overlapping region between the first sub-connection line 341 and the second sub-connection line 342, and the first sub-connection line 341 and the second sub-connection line 342 are electrically connected through the through-hole 61. The cross-sectional area of the through-hole 61 in the horizontal direction is less than or equal to the cross-sectional area of the overlapping region between the first sub-connection line 341 and the second sub-connection line 342 in the horizontal direction.

The other structures of the display panel 200 are the same as those in the display panel 100.

As shown in FIG. 5, some embodiments of the present application provide a display panel 300, which differs from the display panel 100 in that a plurality of first sub-connection lines 341 are sequentially arranged at intervals in the first direction X, and a plurality of second sub-connection lines 342 are sequentially arranged at intervals in the first direction X.

Specifically, the plurality of fourth connection lines 34 in the display panel 300 are arranged at intervals in the first direction X, and the first sub-connection lines 341 and the second sub-connection lines 342 are arranged in a staggered configuration in the first direction X.

In some embodiments of the present application, the orthographic projection of the first sub-connection line 341 on the substrate 10 is located at a side of the orthographic projection of the second sub-connection line 342 on the substrate 10. This arrangement reduces the impedance of the wiring between the chip assembly 20 and the flexible circuit board 40 while simultaneously reducing the parasitic capacitance between the first sub-connection line 341 and the second sub-connection line 32, thereby improving signal stability.

The other structures of the display panel 300 are the same as those in the display panel 100.

As shown in FIG. 6, some embodiments of the present application provide a display panel 400, which differs from the display panel 200 in that the connection trace 30 of the display panel 200 further includes a plurality of fifth connection lines 35 arranged at intervals in the first direction X, a first end of the fifth connection line 35 is electrically connected to the low-level power signal output terminal 41, and a second end of the fifth connection line 35 is electrically connected to the low-level power signal input pin 21.

The display panel 400 includes a first metal layer 50, an insulating layer 60, and a second metal layer 70. The insulating layer 60 is disposed between the first metal layer 50 and the second metal layer 70. The second metal layer 70 is disposed on a side of the first metal layer 50 that is away from the substrate 10. The plurality of fifth connection lines 35 are alternately arranged in the first direction X on both the first metal layer 50 and the second metal layer 70.

In some embodiments of the present application, the fourth connection lines 34 and the fifth connection lines 35 are arranged at intervals in the first direction X. The fourth connection line 34 includes a first sub-connection line 341 and a second sub-connection line 342. The insulating layer 60 is provided with a through-hole 61. An orthographic projection of the first sub-connection line 341 on the substrate 10 covers an orthographic projection of the second sub-connection line 342 on the substrate 10. The cross-sectional area of the through-hole 61 in the horizontal direction is equal to the cross-sectional area of the second sub-connection line 342 in the horizontal direction; the cross-sectional area of the second sub-connection line 342 in the horizontal direction is equal to the cross-sectional area of the first sub-connection line 341 in the horizontal direction.

In some embodiments of the present application, the cross-sectional width of the fifth connection line 35 in the first direction X is greater than the cross-sectional width of the fourth connection line 34 in the first direction X. FIG. 6 exemplarily shows that the fourth connection lines 34 and the fifth connection lines 35 are alternately arranged in the first direction X, and the cross-sectional width of the fifth connection line 35 in the first direction X is greater than the cross-sectional width of the fourth connection line 34 in the first direction X.

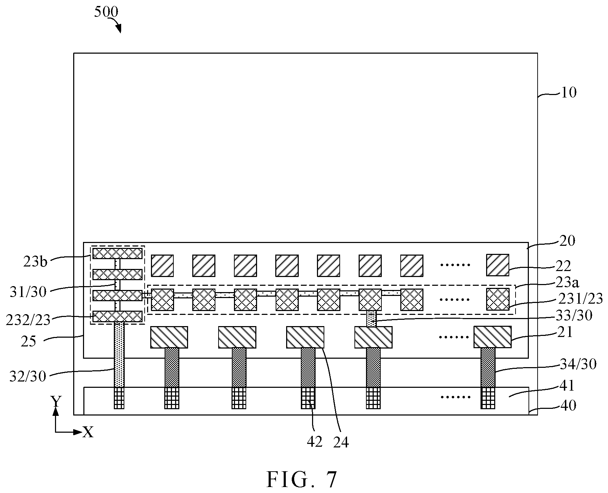

As shown in FIG. 7, some embodiments of the present application provide a display panel 500, which differs from the display panel 100 in that the cross-sectional width of the second connection line 32 in the first direction X is greater than the cross-sectional width of the first connection line 31 in the second direction Y, the cross-sectional width of the third connection line 33 in the first direction is greater than the cross-sectional width of the first connection line 31 in the second direction Y, and the cross-sectional width of the second connection line 32 in the first direction X is equal to the cross-sectional width of the third connection line 33 in the first direction X.

In some embodiments of the present application, the cross-sectional width of the fourth connection line 34 in the first direction X is greater than both the cross-sectional width of the second connection line 32 in the first direction X and the cross-sectional width of the third connection line 33 in the first direction X.

Specifically, the display panel 500 includes a substrate 10, a chip assembly 20, a connection trace 30, and a flexible circuit board 40. The substrate 10 is disposed on the substrate 10. The chip assembly 20 includes a low-level power signal input pin 21, an output pin 22, and dummy pads 23. The low-level power signal input pin 21 and the output pin 22 are spaced apart from each other at opposite sides of the chip assembly 20. At least part of the dummy pads 23 are spaced between the low-level power signal input pin 21 and the output pin 22. The connection trace 30 is disposed on the substrate 10. The connection trace 30 includes first connection lines 31, a second connection line 32, a third connection line 33, and fourth connection lines 34. Two ends of the first connection line 31 are electrically connected to two dummy pads 23, respectively. A first end of the second connection line 32 and a first end of the third connection line 33 are each electrically connected to a first connection line 31. A second end of the second connection line 32 is electrically connected to the low-level power signal input pin 21. The flexible circuit board 40 is disposed on at least one side of the substrate 10. The flexible circuit board 40 includes a low-level power signal output terminal 41 that is electrically connected to both the low-level power signal input pin 21 and a second end of the third connection line 33.

In some embodiments of the present application, a first end of the fourth connection line 34 is electrically connected to the low-level power signal output terminal 41, and a second end of the fourth connection line 34 is electrically connected to the low-level power signal input pin 21. The fourth connection line 34 includes a first sub-connection line 341 and a second sub-connection line 342. The first sub-connection line 341 is disposed on a side of the second sub-connection line 342 that is away from the substrate 10. By configuring the fourth connection line 34 between the chip assembly 20 and the flexible circuit board 40 as a double-layer setup with the first sub-connection line 341 and the second sub-connection line 342, the impedance of the wiring between the chip assembly 20 and the flexible circuit board 40 is further reduced. This helps to decrease the heat generated by the chip assembly 20, thereby controlling the temperature of the chip assembly 20 and preventing excessive temperatures that could affect the output stability of the chip assembly 20 or cause the chip assembly 20 to burn out.

In some embodiments of the present application, an insulating layer 60 is provided between the first sub-connection line 341 and the second sub-connection line 342, and an orthographic projection of the insulating layer 60 on the substrate 10 covers both an orthographic projection of the first sub-connection line 341 on the substrate 10 and an orthographic projection of the second sub-connection line 342 on the substrate 10. That is, the cross-sectional width of the first sub-connection line 341 in the first direction X is greater than or equal to the cross-sectional width of the second sub-connection line 342 in the first direction X, and the first sub-connection line 341 at least partially overlaps with the second sub-connection line 342.

In some embodiments of the present application, the cross-sectional width of the second connection line 32 in the horizontal direction, the cross-sectional width of the first connection line 31 in the horizontal direction, and the cross-sectional width of the third connection line 33 in the horizontal direction are all equal.

In some embodiments of the present application, the chip assembly 20 includes a plurality of low-level power supply signal input pins 21 and a plurality of output pins 22. The plurality of low-level power supply signal input pins 21 are arranged at intervals in the first direction X. The plurality of output pins 22 are arranged at intervals in the first direction X. The low-level power supply signal input pins 21 and the output pins 22 are arranged at intervals in the second direction Y.

In some embodiments of the present application, the plurality of dummy pads 23 include a plurality of first dummy pads 231 and a plurality of second dummy pads 232. The plurality of first dummy pads 231 are arranged at intervals in the first direction X and located between the low-level power signal input pins 21 and the output pins 22. The plurality of second dummy pads 232 are arranged at intervals in the second direction Y and located at a side of the low-level power signal input pins 21 in the first direction X and a side of the output pins 22 in the first direction X. The first direction X intersects the second direction Y. At least part of the first dummy pads 231 are respectively electrically connected through the first connection lines 31 to form a first path 23a. At least part of the second dummy pads 232 are respectively electrically connected through the first connection lines 31 to form a second path 23b. The first path 23a is electrically connected to the second path 23b through a first connection line 31. The first path 23a is electrically connected to the low-level power signal input pin 21 through the second connection line 32. The second path 23b is electrically connected to the low-level power signal output terminal 41 through the third connection line 33.

In some embodiments of the present application, the chip assembly 20 further includes a chip body 25. The chip body 25 is disposed on all of a side of the low-level power signal input pin 21, a side of the output pin 22, and a side of the dummy pad 23 that are away from the substrate 10. The chip body 25 is electrically connected to both the low-level power signal input pin 21 and the output pin 22.

As shown in FIG. 1, a first connection line 31 is disposed between every two adjacent dummy pads 23, and two adjacent dummy pads 23 are electrically connected through a first connection line 31.

In some embodiments of the present application, the first connection lines 31 are disposed among all of the plurality of first dummy pads 231, and every two adjacent first dummy pads 231 are electrically connected through a first connection line 31. The first connection lines 31 are only disposed among part of the second dummy pads 232 at the side close to the flexible circuit board 40, and two adjacent second dummy pads 232 are electrically connected through a first connection line 31. Part of the second dummy pads 232 at the side away from the flexible circuit board 40 are arranged at intervals and are only used to support the chip body 25.

In addition, some embodiments of the present application further provide a display apparatus, which includes the aforementioned display panel and a driving circuit. The driving circuit is electrically connected to the display panel and is configured to drive the display panel.

In the display panel of the display apparatus provided by the present application, at least part of the dummy pads in the chip assembly are electrically connected by setting the first connection lines. The second connection line is used to connect the first connection lines to the low-level power signal input pin, and the low-level power signal output terminal of the flexible circuit board. Additionally, the third connection line connects the first connection lines to the low-level power signal output terminal of the flexible circuit board. Furthermore, the display panel employs a double-layer configuration for the fourth connection line, which connects the chip assembly to the flexible circuit board, to reduce the impedance of the wiring between them. This effectively reduces the heat generated by the driver chip, thereby controlling the temperature of the driver chip.

The above provides a detailed introduction to the display panel and the display apparatus as described in the embodiments of the present application. The explanation of these embodiments is intended solely to help understand the core ideas of the present application and should not be construed as limiting the scope of protection of the present application.

## Claims

1. A display panel, comprising:
a substrate;
a chip assembly disposed on the substrate, wherein the chip assembly comprises a low-level power signal input pin, a high-level power signal input pin, an output pin, and dummy pads, the low-level power signal input pin and the high-level power signal input pin are spaced apart from the output pin at opposite sides of the chip assembly, and at least part of the dummy pads are spaced between the low-level power signal input pin and the output pin;
a connection trace disposed on the substrate, wherein the connection trace comprises first connection lines, a second connection line, and a third connection line, two ends of one of the first connection lines are electrically connected to two of the dummy pads, respectively, a first end of the second connection line and a first end of the third connection line are each electrically connected to one of the first connection lines, and a second end of the second connection line is electrically connected to the low-level power signal input pin; and
a flexible circuit board disposed on at least one side of the substrate, wherein the flexible circuit board comprises a low-level power signal output terminal and a high-level power signal output terminal, the low-level power signal output terminal is electrically connected to both the low-level power signal input pin and a second end of the third connection line, and the high-level power signal output terminal is electrically connected to the high-level power signal input pin.

2. The display panel according to claim 1, wherein the plurality of dummy pads comprise a plurality of first dummy pads and a plurality of second dummy pads, the plurality of first dummy pads are arranged at intervals in a first direction and located between the low-level power signal input pin and the output pin;
the plurality of second dummy pads are arranged at intervals in a second direction and located at a side of the low-level power supply signal input pin and a side of the output pin in the first direction, wherein the first direction intersects the second direction; and
wherein at least part of the plurality of first dummy pads are respectively electrically connected through the first connection lines to form a first path, at least part of the plurality of second dummy pads are respectively electrically connected through the first connection lines to form a second path, and the first path is electrically connected to the second path through one of the first connection lines; the first path is electrically connected to the low-level power signal input pin through the second connection line, and the second path is electrically connected to the low-level power signal output terminal through the third connection line.

3. The display panel according to claim 2, wherein the first connection lines are disposed among all of the plurality of first dummy pads, and every two adjacent ones of the plurality of first dummy pads are electrically connected through one of the first connection lines; and
wherein the first connection lines are disposed among part of the plurality of second dummy pads close to a side of the flexible circuit board, and two adjacent ones of the plurality of second dummy pads are electrically connected through one of the first connection lines.

4. The display panel according to claim 1, wherein the connection trace further comprises a fourth connection line, a first end of the fourth connection line is electrically connected to the low-level power signal output terminal, and a second end of the fourth connection line is electrically connected to the low-level power signal input pin;
wherein the fourth connection line comprises a first sub-connection line and a second sub-connection line, and the first sub-connection line is disposed on a side of the second sub-connection line away from the substrate; both a first end of the first sub-connection line and a first end of the second sub-connection line are electrically connected to the low-level power signal output terminal, and both a second end of the first sub-connection line and a second end of the second sub-connection line are electrically connected to the low-level power signal input pin; and
wherein an insulating layer is provided between the first sub-connection line and the second sub-connection line, and an orthographic projection of the insulating layer on the substrate covers both an orthographic projection of the first sub-connection line on the substrate and an orthographic projection of the second sub-connection line on the substrate.

5. The display panel according to claim 4, wherein the insulating layer is provided with a through-hole, and the first sub-connection line is electrically connected to the second sub-connection line through the through-hole.

6. The display panel according to claim 5, wherein the plurality of first sub-connection lines are sequentially arranged at intervals in a first direction, and the plurality of second sub-connection lines are sequentially arranged at intervals in the first direction.

7. The display panel according to claim 6, wherein the orthographic projection of the first sub-connection line on the substrate at least partially covers the orthographic projection of the second sub-connection line on the substrate.

8. The display panel according to claim 4, wherein the connection trace further comprises a plurality of fifth connection lines arranged at intervals in a first direction, a first end of one of the plurality of fifth connection lines is electrically connected to the low-level power signal output terminal, and a second end of the one of the plurality of fifth connection lines is electrically connected to the low-level power signal input pin; and
wherein the display panel further comprises a first metal layer, the insulating layer, and a second metal layer, the first metal layer, the insulating layer, and the second metal layer are disposed on the substrate, the insulating layer is disposed between the first metal layer and the second metal layer, and the second metal layer is disposed on a side of the first metal layer away from the substrate, wherein the plurality of fifth connection lines are arranged in a staggered configuration in the first direction on both the first metal layer and the second metal layer.

9. The display panel according to claim 8, wherein a cross-sectional width of one of the plurality of fifth connection lines in the first direction is greater than a cross-sectional width of the fourth connection line in the first direction.

10. The display panel according to claim 1, wherein a cross-sectional width of the second connection line in a horizontal direction is greater than a cross-sectional width of one of the first connection lines in the horizontal direction, and a cross-sectional width of the third connection line in the horizontal direction is greater than the cross-sectional width of the one of the first connection lines in the horizontal direction.

11. A display apparatus, comprising a display panel and a driving circuit, wherein the driving circuit is electrically connected to the display panel and configured to drive the display panel, wherein the display panel comprises:
a substrate;
a chip assembly disposed on the substrate, wherein the chip assembly comprises a low-level power signal input pin, a high-level power signal input pin, an output pin, and dummy pads, the low-level power signal input pin and the high-level power signal input pin are spaced apart from the output pin at opposite sides of the chip assembly, and at least part of the dummy pads are spaced between the low-level power signal input pin and the output pin;
a connection trace disposed on the substrate, wherein the connection trace comprises first connection lines, a second connection line, and a third connection line, two ends of one of the first connection lines are electrically connected to two of the dummy pads, respectively, a first end of the second connection line and a first end of the third connection line are each electrically connected to one of the first connection lines, and a second end of the second connection line is electrically connected to the low-level power signal input pin; and
a flexible circuit board disposed on at least one side of the substrate, wherein the flexible circuit board comprises a low-level power signal output terminal and a high-level power signal output terminal, the low-level power signal output terminal is electrically connected to both the low-level power signal input pin and a second end of the third connection line, and the high-level power signal output terminal is electrically connected to the high-level power signal input pin.

12. The display apparatus according to claim 11, wherein the plurality of dummy pads comprise a plurality of first dummy pads and a plurality of second dummy pads, the plurality of first dummy pads are arranged at intervals in a first direction and located between the low-level power signal input pin and the output pin;
the plurality of second dummy pads are arranged at intervals in a second direction and located at a side of the low-level power supply signal input pin and a side of the output pin in the first direction, wherein the first direction intersects the second direction; and
wherein at least part of the plurality of first dummy pads are respectively electrically connected through the first connection lines to form a first path, at least part of the plurality of second dummy pads are respectively electrically connected through the first connection lines to form a second path, and the first path is electrically connected to the second path through one of the first connection lines; the first path is electrically connected to the low-level power signal input pin through the second connection line, and the second path is electrically connected to the low-level power signal output terminal through the third connection line.

13. The display apparatus according to claim 12, wherein the first connection lines are disposed among all of the plurality of first dummy pads, and every two adjacent ones of the plurality of first dummy pads are electrically connected through one of the first connection lines; and
wherein the first connection lines are disposed among part of the plurality of second dummy pads close to a side of the flexible circuit board, and two adjacent ones of the plurality of second dummy pads are electrically connected through one of the first connection lines.

14. The display apparatus according to claim 11, wherein the connection trace further comprises a fourth connection line, a first end of the fourth connection line is electrically connected to the low-level power signal output terminal, and a second end of the fourth connection line is electrically connected to the low-level power signal input pin;
wherein the fourth connection line comprises a first sub-connection line and a second sub-connection line, and the first sub-connection line is disposed on a side of the second sub-connection line away from the substrate; both a first end of the first sub-connection line and a first end of the second sub-connection line are electrically connected to the low-level power signal output terminal, and both a second end of the first sub-connection line and a second end of the second sub-connection line are electrically connected to the low-level power signal input pin; and
wherein an insulating layer is provided between the first sub-connection line and the second sub-connection line, and an orthographic projection of the insulating layer on the substrate covers both an orthographic projection of the first sub-connection line on the substrate and an orthographic projection of the second sub-connection line on the substrate.

15. The display apparatus according to claim 14, wherein the insulating layer is provided with a through-hole, and the first sub-connection line is electrically connected to the second sub-connection line through the through-hole.

16. The display apparatus according to claim 15, wherein the plurality of first sub-connection lines are sequentially arranged at intervals in a first direction, and the plurality of second sub-connection lines are sequentially arranged at intervals in the first direction.

17. The display apparatus according to claim 16, wherein the orthographic projection of the first sub-connection line on the substrate at least partially covers the orthographic projection of the second sub-connection line on the substrate.

18. The display apparatus according to claim 14, wherein the connection trace further comprises a plurality of fifth connection lines arranged at intervals in a first direction, a first end of one of the plurality of fifth connection lines is electrically connected to the low-level power signal output terminal, and a second end of the one of the plurality of fifth connection lines is electrically connected to the low-level power signal input pin; and
wherein the display panel further comprises a first metal layer, the insulating layer, and a second metal layer, the first metal layer, the insulating layer, and the second metal layer are disposed on the substrate, the insulating layer is disposed between the first metal layer and the second metal layer, and the second metal layer is disposed on a side of the first metal layer away from the substrate, wherein the plurality of fifth connection lines are arranged in a staggered configuration in the first direction on both the first metal layer and the second metal layer.

19. The display apparatus according to claim 18, wherein a cross-sectional width of one of the plurality of fifth connection lines in the first direction is greater than a cross-sectional width of the fourth connection line in the first direction.

20. The display apparatus according to claim 11, wherein a cross-sectional width of the second connection line in a horizontal direction is greater than a cross-sectional width of one of the first connection lines in the horizontal direction, and a cross-sectional width of the third connection line in the horizontal direction is greater than the cross-sectional width of the one of the first connection lines in the horizontal direction.
